# EUROPEAN PATENT SPECIFICATION

(11) **EP 4 582 820 B1**
(45) Date of publication and mention of the grant of the patent: **30.09.2026**
(21) Application number: 23879979.5
(22) Date of filing: 11.08.2023
(51) Int. Cl.: G01R 31/34, G01R 31/392, G01R 31/385, G06N 3/08, G05B 23/02

(54) **MONITORING SYSTEM AND OPERATING METHOD THEREFOR**
ÜBERWACHUNGSSYSTEM UND BETRIEBSVERFAHREN DAFÜR
SYSTÈME DE SURVEILLANCE ET SON PROCÉDÉ DE FONCTIONNEMENT

(30) Priority: 19.10.2022 KR 20220134711
(43) Date of publication of application: 09.07.2025
(73) Proprietor: LG Energy Solution, Ltd., Seoul 07335 (KR)
(72) Inventor: LEE, Jong Hyun, Daejeon 34122 (KR)
(74) Representative: BCKIP Part mbB
(86) International application number: PCT/KR2023/011927
(87) International publication number: WO 2024/085396

(56) References cited:
- EP-A1- 4 050 354
- WO-A1-2022/101460
- KR-A- 20120 064 940
- KR-A- 20150 089 722
- KR-A- 20200 081 554
- KR-A- 20220 044 549
- US-A1- 2017 154 283
- US-B2- 8 676 356

## Description

### [TECHNICAL FIELD]

### CROSS-REFERENCE TO RELATED APPLICATION

Priority is claimed from Korean Patent Application No. 10-2022-0134711 filed on October 19, 2022.

### TECHNICAL FIELD

The present invention relates to a monitoring system and operating method thereof.

### [BACKGROUND ART]

Electric vehicles receive power from the outside to charge the battery cells, and then drive the motor with the voltage charged in the battery cells to obtain power. A battery cell of an electric vehicle is manufactured by accommodating an electrode assembly in a battery case and injecting an electrolyte into the battery case.

If the welding part of the battery cell is partially or completely detached due to external impact or welding defects, the battery cell may deteriorate or explode. Therefore, the battery process system monitors the load factor of the servo motor included in the battery manufacturing device to quickly diagnose and analyze the fault in case of a fault in the battery manufacturing process.

Typically, the battery process system monitors the load factor of the servo motor based on a fixed control line, leading to issues such as over-inspection due to the inability to update the fixed control line when battery process conditions change, and a high administrative burden for administrators resulting from control line updates. On the other hand, a method of monitoring the load factor of the servo motor based on the Moving Average approach for the control line automatically updates the control line according to changes in battery process conditions, resulting in lower administrative burdens for administrators; however, it cannot detect the gradual increase in the load factor of the servo motor, leading to mis-inspection problem.

EP 4 050 354 A1, which relates to the preamble of the attached independent claims, discloses a method and a device for monitoring the condition of a motor, the motor being driven by a power source that provides signals to the motor. The method and device sense a motor signal, detect predetermined operating conditions of the motor, and if the motor operates in predetermined conditions detect the instants of zero-crossing of the sensed signal, determine the time intervals between two zero-crossing instants, estimate plural envelopes of the determined time intervals in order to obtain an estimated pattern of envelopes, each envelope being determined over a number of determined time intervals, and determine from the operating conditions of the motor and the pattern of envelopes whether the motor has a fault and/or a level of the fault.

WO 2022/101460 A1 discloses a monitoring device for monitoring an electric motor, specifically of a laboratory system. The monitoring device comprises: at least one receiving unit configured for receiving information on at least one amount of acceleration energy required for accelerating the electric motor from at least one first motion state to at least one second motion state, and at least one evaluation unit configured for evaluating the information on the amount of acceleration energy and for determining at least one item of information on a wearing status of the electric motor.

US 8,676,356 B2 discloses a system and method for determining unknown values of certain motor parameters includes a motor input device connectable to an electric motor having associated therewith values for known motor parameters and an unknown value of at least one motor parameter. A motor input device includes a processing unit that receives a first input from the electric motor comprising values for the known motor parameters for the electric motor and receives a second input comprising motor data on a plurality of reference motors, including values for motor parameters corresponding to the known motor parameters of the electric motor and values for motor parameters corresponding to the at least one unknown motor parameter value of the electric motor. The processor determines the unknown value of the at least one motor parameter from the first input and the second input and determines a motor management strategy for the electric motor based thereon.

### [DISCLOSURE]

### [TECHNICAL PROBLEM]

The object of the present invention is to provide a monitoring system and operating method thereof that are capable of analyzing and controlling the load factor of a servo motor in real time using a moving average control line of a battery process system. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

The above technical object of the invention disclosed in this document are not limited to the aforesaid, and other advantages not described herein with be clearly understood by those skilled in the art from the descriptions below.

### [TECHNICAL SOLUTION]

A monitoring system according to the invention is disclosed in claim 1.

According to the invention, the controller preprocesses the drive data based on the parameter and generates the reference information based on the preprocessed drive data.

According to the invention, the data management unit extracts a first interval to distinguish first drive data obtained during a predetermined period of time before a reference point to be used for generating the reference information and a second interval to distinguish second drive data to be excluded for generating the reference information among the drive data by applying the drive data to an optimizer intelligence model.

According to an embodiment, the controller may generate third drive data by excluding the second drive data obtained during the second interval from the first drive data obtained during the first interval among the drive data.

According to an embodiment, the controller may determine whether a duration corresponding to the third drive data is equal to or longer than a threshold period and generate the reference information based on the third drive data in response to the third drive data being equal to or longer than the threshold period.

According to an embodiment, the controller may calculate a mean and a standard deviation of the third drive data and generate the reference information based on the mean and the standard deviation.

According to an embodiment, the controller may generate a count value based on whether the third drive data exceeds the reference information and determine whether the motor is malfunctioning based on whether the generated count value exceeds a threshold count value.

According to an embodiment, the controller may determine that the motor is malfunctioning based on the count value being greater than the threshold count value and generate an abnormal signal for the motor.

According to an embodiment, the controller may determine that the motor is functioning normally based on the count value being equal to or less than the threshold count value.

An operating method of a monitoring system according to the invention is disclosed in claim 8.

According to the invention, the generating of the reference information for managing the state of the motor based on the parameter include preprocessing the drive data based on the parameter and generating the reference information based on the preprocessed drive data.

According to the invention, the extracting of the parameter representing the characteristic of the drive data by applying the drive data to the artificial intelligence model may include extracting a first interval to distinguish first drive data obtained during a predetermined period of time before a reference point to be used for generating the reference information and a second interval to distinguish second drive data to be excluded for generating the reference information among the drive data by applying the drive data to an optimizer intelligence model.

According to an embodiment, the generating of the reference information for managing the state of the motor based on the parameter may include generating third drive data by excluding the second drive data obtained during the second interval from the first drive data obtained during the first interval among the drive data.

According to an embodiment, the generating of the reference information for managing the state of the motor based on the parameter may include determining whether a duration corresponding to the third drive data is equal to or longer than a threshold period, and generating the reference information based on the third drive data in response to the third drive data being equal to or longer than the threshold period.

According to an embodiment, the generating of the reference information for managing the state of the motor based on the parameter may include calculating a mean and a standard deviation of the third drive data and generating the reference information based on the mean and the standard deviation.

According to an embodiment, the generating of the reference information for managing the state of the motor based on the parameter may include generating a count value based on whether the third drive data exceeds the reference information, and determining whether the motor is malfunctioning based on whether the generated count value exceeds a threshold count value.

According to an embodiment, the generating of the reference information for managing the state of the motor based on the parameter may include determining that the motor is malfunctioning based on the count value being greater than the threshold count value and generating an abnormal signal for the motor.

According to an embodiment, the generating of the reference information for managing the state of the motor based on the parameter may include determining that the motor is functioning normally based on the count value being equal to or less than the threshold count value.

### [ADVANTAGEOUS EFFECTS]

The monitoring system and operating method thereof according to the invention is capable of analyzing and controlling the load factor of a servo motor in real time using a moving average control line.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### [DESCRIPTION OF DRAWINGS]

FIG. 1 is a schematic diagram illustrating a battery process system according to an embodiment disclosed in this document;
FIG. 2 is a block diagram illustrating a configuration of a monitoring system according to an embodiment disclosed in this document;
FIG. 3 is a flowchart illustrating a parameter extraction operation of a data management unit according to an embodiment disclosed in this document;
FIG. 4 is a diagram illustrating a third drive data extraction operation of a controller according to an embodiment disclosed in this document;
FIG. 5 is a flowchart illustrating a reference information generation operation of a controller according to an embodiment disclosed in this document;
FIG. 6 is a flowchart illustrating an operation method of a monitoring system according to an embodiment disclosed in this document; and
FIG. 7 is a diagram illustrating a hardware configuration of a computing system implementing a monitoring system according to an embodiment disclosed in this document.

### [MODE FOR INVENTION]

Hereinafter, embodiments disclosed in this document will be described in detail with reference to exemplary drawings. In assigning reference numerals to the components of each drawing, it should be noted that the same components have the same reference numerals as much as possible even if they are displayed in different drawings. Detailed description of a well-known structure or function incorporated in the embodiments disclosed in this document may be omitted to avoid obscuring the understanding of the embodiments disclosed in this document.

Terms such as "the first", "the second", "A", "B", "(a)", and "(b)" may be used to describe components of the embodiments disclosed in this document. These terms are only used only to distinguish one component from another component, and the nature, sequence, or order of the corresponding components are not limited by the term. Unless otherwise defined herein, all terms including technical or scientific terms used herein have the same meanings as commonly understood by those skilled in the art to which the embodiments disclosed in this document belongs. It will be further understood that terms, such as those defined in commonly used dictionaries, should be interpreted as having a meaning that is consistent with their meaning in the context of the relevant art and should not be interpreted in an idealized or overly formal sense unless expressly so defined herein.

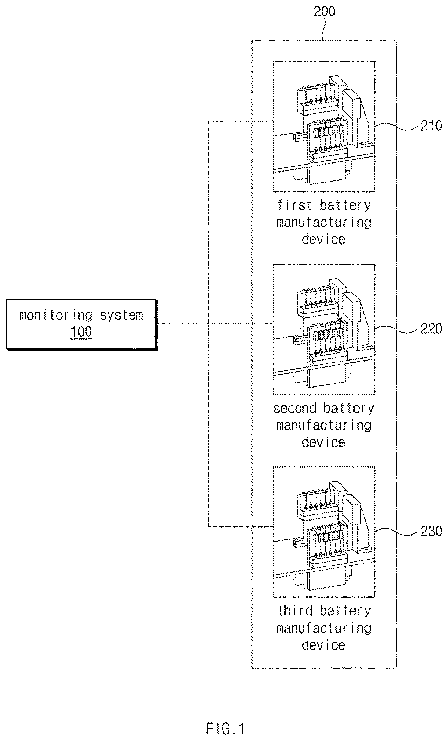

FIG. 1 is a schematic diagram illustrating a battery process system according to an embodiment disclosed in this document.

According to various embodiments, a battery may include a battery cell, which is the basic unit of a battery that can be charged and discharged to use electrical energy. A battery cell may be a lithium-ion (Li-iOn) battery, a lithium-ion polymer (Li-iOn polymer) battery, a nickel-cadmium (Ni-Cd) battery, or a nickel-metal hydride (Ni-MH) battery and is not limited to these. The battery cell may supply power to a target device (not shown). To this end, the battery cell may be electrically connected to the target device. Here, the target device may include an electrical, electronic, or mechanical device operated by receiving power from a battery pack (not shown) including a plurality of battery cells. For example, the target device may be, but is not limited to, small products such as digital cameras, P-DVDs, MP3P, mobile phones, PDAs, portable game devices, Power Tools, and E-bikes, as well as large products requiring high power such as electric or hybrid vehicles, power storage devices for storing excess generated power or renewable energy, or backup power storage devices.

A battery cell may include an electrode assembly, a battery case in which the electrode assembly is accommodated, and an electrolyte injected into the battery case to activate the electrode assembly. The electrode assembly is formed by interposing a separator between a cathode plate formed by coating a cathode current collector with a cathode active material and a anode plate formed by coating a anode current collector with a anode active material, and depending on the type of battery case, the electrode assembly may be manufactured in a jelly roll type or stack type and accommodated inside the battery case. The battery case serves as an exterior material that maintains the shape of the battery and protects the battery from external impact, and battery cells may be classified into cylindrical, prismatic, and pouch types according to the type of battery case.

According to an embodiment, a battery cell may be manufactured through a series of manufacturing processes, including an electrode manufacturing, an assembly process, and a chemical process. Here, the assembly process involves assembling the positive electrode plate and negative electrode plate produced through the electrode manufacturing process and injecting electrolyte, and may include the notching process, winding process, assembly process, and packaging process.

The packaging process may be defined as the process of injecting and sealing the electrode assembly and electrolyte in the battery case. For a cylindrical battery cell, the electrode assembly is mounted in a cylindrical metal can, the negative tab extended from the negative electrode of the electrode assembly is welded to the bottom of the can, and the positive tab extended from the positive electrode of the electrode assembly is welded to the top cap of the cap assembly while the electrode assembly and electrolyte are in place.

Hereinafter, a description is made an exemplary case where the battery process system is applied to the assembly process. For example, the battery process system may be used in the packaging process of the assembly process system, but it is not limited thereto.

With reference to FIG. 1, the battery process system may include a monitoring system 100 and at least one battery manufacturing device 200.

The monitoring system 100 may collect and analyze data from the battery manufacturing device 200 operating within the battery process system in real-time. The monitoring system 100 may collect and analyze operational data from the at least one battery manufacturing device 200. Furthermore, the monitoring system 100 may collect operational data from a process control device (PLC) (not shown) that controls the battery manufacturing device 200. Here, the operational data of the battery manufacturing device 200 may include operational records of the battery manufacturing device 200.

For example, the monitoring system 100 may collect and analyze data or graph data generated within the battery manufacturing process system, such as process progress status, alarm occurrence, temperature, pressure, quantity, etc., from the battery manufacturing device 200.

The monitoring system 100 may detect abnormal data within the operational data of the battery manufacturing device 200. The monitoring system 100 may analyze the battery manufacturing device 200 corresponding to the abnormal data.

The battery manufacturing device 200 may include a first battery manufacturing device 210, a second battery manufacturing device 220, and a third battery manufacturing device 230. Although three battery manufacturing devices 200 are depicted in FIG. 1, this is not limiting, and the battery manufacturing devices 200 may include n (where n is a natural number greater than or equal to 1) devices.

According to an embodiment, the battery manufacturing device 200 may weld the positive tab of the electrode assembly of a battery cell and the top cap of the cap assembly during the packaging process of the battery cell.

According to an embodiment, the monitoring system 100 may acquire drive data of motors associated with the plurality of battery manufacturing devices 200. Here, the motors may include, for example, a servo motor. The servo motor is a motor designed to quickly and accurately follow the user's position or speed control commands, including a control drive board.

The monitoring system 100 may, for example, manage the load factor of servo motors. The monitoring system 100 may monitor the gradual increase in the load factor of motors associated with the plurality of battery manufacturing devices 200 using the moving average calculation method. When operational conditions of the plurality of battery manufacturing devices 200 change, the monitoring system 100 may automatically calculate the load factor of battery manufacturing devices 200 using the moving average calculation method.

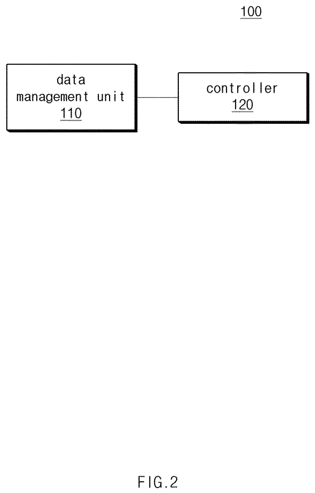

FIG. 2 is a block diagram illustrating a configuration of a monitoring system 100 according to an embodiment disclosed in this document.

With reference to FIG. 2, the monitoring system 100 includes a data management unit 110 and a controller 120.

The data management unit 110 acquires time-based drive data of the motors associated with battery manufacturing devices 200. For example, the data management unit 110 may automatically log drive data of the motors associated with the battery manufacturing devices 200. For example, the data management unit 110 may collect drive data of motors by setting an automatic data logging sampling interval of 0.1 seconds.

The data management unit 110 applies the drive data to an artificial intelligence model to extract parameters representing the characteristics of the drive data. Here, the parameters include for example, a first interval and a second interval. First, the first interval is a value for distinguishing data to be used for managing the load factors of the motors. That is, the first interval serves as a reference interval for determining data to be used for managing the load factors of the motors by extracting some of the drive data. For example, with a first interval of one week, the monitoring system 100 may manage the load factors of the motors using the drive data obtained over the past week among the drive data.

The second interval is a value for distinguishing data to be excluded for managing the load factors of motors among the drive data. That is, the second interval serves as a reference interval for determining data to be excluded for managing the load factors of the motors by extracting some of the drive data. For example, with a second interval of 12 hours, the monitoring system 100 may manage the load factors of the motors by excluding drive data obtained over the last 12 hours among the drive data.

The data management unit 110 applies the drive data to an optimizer artificial intelligence model to extract parameters representing the characteristics of the drive data. Here, the optimizer artificial intelligence model may use the gradient descent method to extract parameters representing the characteristics of the drive data.

According to the invention, the data management unit 110 extracts the first and second intervals optimized for load factor management of the motors by applying the drive data to the optimizer artificial intelligence model.

The controller 120 may preprocess the drive data based on the extracted parameters. In detail, the controller 120 may extract the first drive data, which is the drive data acquired during the first interval before the current point, from the entire drive data acquired. In addition, the controller 120 may extract the second drive data, which is the drive data acquired during the second interval before the current point, from the entire drive data. The controller 120 may generate the third drive data by excluding the second drive data from the extracted first drive data.

The controller 120 may generate reference information based on the preprocessed third drive data. Here, the reference information may include reference information that can be used to determine the load factor of the motor.

The controller 120 may determine whether the period corresponding to the third drive data is equal to or longer than a threshold period. When the third drive data exceeds the threshold period, the controller 120 may generate reference information based on the third drive data. For example, when the third drive data generated by preprocessing the drive data is equal to or larger than the data acquired for 3.5 days, the controller 120 may generate the reference information based on the third drive data.

The controller 120 may calculate the mean µ and standard deviation σ of the third drive data. The controller 120 may generate a plurality of reference information based on the mean µ and standard deviation σ of the third drive data. For example, the controller 120 may generate the first reference information of 'µ + 5*σ' by adding the value obtained by multiplying the standard deviation σ by 5 to the mean µ of the third drive data. In addition, for example, the controller 120 may generate the second reference information of 'µ + 9*σ' by adding the value obtained by multiplying the standard deviation σ by 9 to the mean µ of the third drive data.

The controller 120 may generate a count value based on whether the third drive data exceeds the reference information. In detail, the controller 120 may determine whether the count value, which is generated based on whether the third drive data exceeds the reference information, is greater than a threshold count value to determine whether the motor is malfunctioning. When the generated count value is greater than the threshold count value, the controller 120 may determine that the motor is malfunctioning and may generate an abnormal signal for the motor. In addition, when the count value is equal to or less than the threshold count value, the controller 120 may determine that the motor is functioning normally.

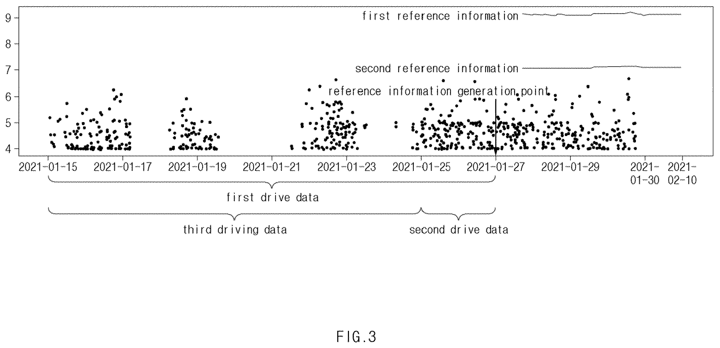

FIG. 3 is a flowchart illustrating a parameter extraction operation of a data management unit according to an embodiment disclosed in this document.

With reference to FIG. 3, at step S101, the data management unit 110 may acquire drive data of the motor.

At step S102, the data management unit 110 may classify the drive data of the motor into test data and training data.

At step S103, the data management unit 110 may input the training data among the drive data of the motor into an optimization function. At step S103, the data management unit 110 may set the initial value (Initiator), threshold value (Threshold), and number of learning iteration of the optimization function. At step S103, for example, the data management unit 110 may input parameter values extracted randomly based on the drive data into the optimization function. Here, the randomly extracted parameter values may include multiples of the standard deviation σ to be used in the first interval, second interval, or reference information. For instance, the randomly extracted parameter values may include 7 days, 14 days, and 21 days for the first interval, 6 hours, 12 hours, and 1 day for the second interval, and multiples of the standard deviation σ such as 3 times, 4 times, and 5 times for the reference information.

At step S104, the data management unit 110 may calculate the accuracy of the optimization function. At step S104, the data management unit 110 may use the accuracy of the optimization function to determine whether 'Accuracy(i) - Accuracy(i-1)' is equal to or less than the first threshold value (Threshold 1). Here, 'i' represents the number of learning iterations of the optimization function.

At step S105, the data management unit 110 may use the accuracy of the optimization function to determine whether 'Accuracy(i)' is equal to or greater than the second threshold value (Threshold 2). Here, 'i' represents the number of learning iterations of the optimization function. At step S105, when 'Accuracy(i)' is equal to or greater than the second threshold value (Threshold 2), the data management unit 110 may terminate the operation of the optimization function.

At step S106, the data management unit 110 may determine whether the number of learning iteration i is equal to or greater than 1000 when 'Accuracy(i) - Accuracy(i-1)' is greater than the first threshold value (Threshold 1) or when 'Accuracy(i)' is less than the second threshold value (Threshold 2). At step S106, when the number of learning iteration i is greater than or equal to 1000, the data management unit 110 may terminate the operation of the optimization function.

At step S107, the data management unit 110 may calculate the final accuracy of the optimization function using the test data.

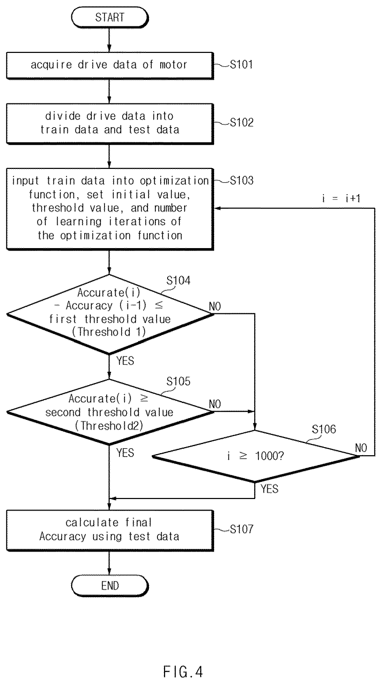

FIG. 4 is a diagram illustrating a third drive data extraction operation of a controller according to an embodiment disclosed in this document.

With reference to FIG. 4, the controller 120 may extract the first drive data, which is the drive data acquired during the first interval before the reference information generation point, from the entire drive data. For example, when the first interval extracted by the data management unit 110 is 7 days, 14 days, or 21 days, the controller 120 may extract the first drive data obtained during the respective 7-day, 14-day, or 21-day periods before the reference information generation point from the entire drive data.

Additionally, the controller 120 may extract the second drive data obtained during the second interval before the reference information generation point from the entire drive data. For instance, when the second interval extracted by the data management unit 110 is 12 hours, 1 day, 2 days, or 3 days, the controller 120 may extract the second drive data obtained during the respective 12-hour, 1-day, 2-day, or 3-day periods before the reference information generation point from the entire drive data.

The controller 120 may generate the third drive data by excluding the second drive data from the extracted first drive data. For example, when the first drive data is obtained during the 7, 14, or 21 days before the reference information generation point, and the second drive data is obtained during the 12 hours, 1 day, 2 days, or 3 days before the reference information generation point, the controller 120 may generate third drive data by excluding the drive data obtained during the 12 hours, 1 day, 2 days, or 3 days before the reference information generation point from the first drive data obtained during the 7, 14, or 21 days before the time point of generating the reference information corresponding to the second drive data.

The controller 120 may generate reference information based on the preprocessed third drive data.

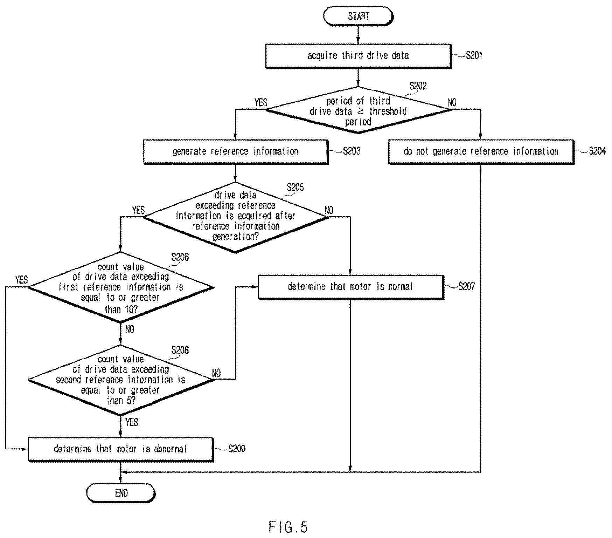

FIG. 5 is a flowchart illustrating a reference information generation operation of a controller according to an embodiment disclosed in this document.

With reference to FIG. 5, at step S201, the controller 120 may preprocess drive data based on the extracted parameters. At step S201, the controller 120 may generate the third drive data by excluding the second drive data from the extracted first drive data.

At step S202, the controller 120 may determine whether the period corresponding to the third drive data is equal to or longer than a threshold period.

At step S202, the controller 120 may determine whether the third drive data exceeds the threshold period. At step S202, for example, the controller 120 may determine whether the third drive data is equal to or larger than the data obtained during the period of 3.5 days.

At step S203, the controller 120 may generate reference information based on the third drive data. At step S203, the controller 120 may calculate the mean µ and standard deviation σ of the third drive data. At step S203, the controller 120 may generate the first reference information of 'µ + 5*σ' by adding the value obtained by multiplying the standard deviation σ by 5 to the mean µ of the third drive data. At step S203, the controller 120 may generate the second reference information of 'µ + 9*σ' by adding the value obtained by multiplying the standard deviation σ by 9 to the mean µ of the third drive data.

At step S204, the controller 120 may does not generate reference information when the third drive data does not exceed the threshold period.

At step S205, the controller may determine whether the drive data obtained after generating the reference information exceeds the reference information. At step S205, for example, the controller 120 may determine whether drive data obtained during the recent 10 minutes exceeds the reference information.

At step S206, the controller 120 may generate a count value based on whether the third drive data exceeds the reference information. For example, at step S206, the controller 120 may determine whether the count value of drive data exceeding the first reference information among the third drive data is equal to or greater than 10.

At step S207, the controller 120 may determine that the motor is functioning normally when drive data exceeding the reference information has not been obtained after the reference information is generated.

At step S208, the controller 120 may determine whether the count value of drive data exceeding the second reference information among the third drive data is equal to or greater than 5.

At step S209, the controller 120 may determine that the motor is malfunctioning when the count value of drive data exceeding the first reference information among the third drive data is equal to or greater than 10, or when the count value of drive data exceeding the second reference information among the third drive data is equal to or greater than 5, in which case the controller may determine.

As described above, the monitoring system 100 and operating method thereof according to an embodiment disclosed in this document is capable of analyzing and controlling the load factor of a servo motor in real time using a moving average control line.

Furthermore, the monitoring system 100 may compare past and current drive data of a motor by creating a management line by excluding the drive data acquired during a predetermined period before the reference point from the extracted motor drive data.

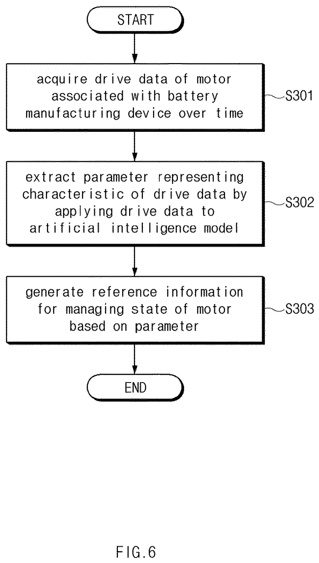

FIG. 6 is a flowchart illustrating an operation method of a monitoring system according to an embodiment disclosed in this document.

Hereinafter, a description is made of the operating method of the monitoring system 100 with reference to FIGS. 1 to 5.

Since the monitoring system 100 may be substantially identical with the monitoring system 100 described with reference to FIGS. 1 to 5, a brief description is provided below to avoid redundancy in the explanation.

With reference to FIG. 6, the operation of the monitoring system 100 may include acquiring drive data of a motor associated with the operational battery manufacturing device over time at step S301, extracting parameters representing the characteristics of the drive data by applying the drive data to an artificial intelligence model at step S302, and generating reference information for managing the state of the motor based on the parameters at step S303.

At step S301, the data management unit 110 may acquire time-based drive data of the motors associated with battery manufacturing devices 200. At step S301, for example, the data management unit 110 may automatically log drive data of the motors associated with the battery manufacturing devices 200.

At step S302, the data management unit 110 may apply the drive data to an artificial intelligence model to extract parameters representing the characteristics of the drive data. Here, the parameters may include, for example, a first interval and a second interval. First, the first interval is a value for distinguishing data to be used for managing the load factors of the motors. That is, the first interval serves as a reference interval for determining data to be used for managing the load factors of the motors by extracting some of the drive data. The second interval is a value for distinguishing data to be excluded for managing the load factors of motors among the drive data. That is, the second interval serves as a reference interval for determining data to be excluded for managing the load factors of the motors by extracting some of the drive data.

At step S302, the data management unit 110 may apply the drive data to an optimizer artificial intelligence model to extract parameters representing the characteristics of the drive data. At step S302, for example, the data management unit 110 may extract the first and second intervals optimized for load factor management of the motors by applying the drive data to the optimizer artificial intelligence model.

At step S303, the controller 120 may preprocess the drive data based on the extracted parameters. At step S303, in detail, the controller 120 may extract the first drive data, which is the drive data acquired during the first interval before the current point, from the entire drive data acquired.

At step S303, the controller 120 may extract the second drive data, which is the drive data acquired during the second interval before the current point, from the entire drive data.

At step S303, the controller 120 may generate the third drive data by excluding the second drive data from the extracted first drive data.

At step S303, the controller 120 may generate reference information based on the preprocessed third drive data. Here, the reference information may include reference information that can be used to determine the load factor of the motor.

At step S303, the controller 120 may determine whether the period corresponding to the third drive data is equal to or longer than a threshold period. At step S303, the controller 120 may generate reference information based on the third drive data when the third drive data exceeds the threshold period.

At step S303, the controller 120 may calculate the mean µ and standard deviation σ of the third drive data. At step S303, the controller 120 may generate a plurality of reference information based on the mean µ and standard deviation σ of the third drive data.

At step S303, for example, the controller 120 may generate the first reference information of 'µ + 5*α' by adding the value obtained by multiplying the standard deviation σ by 5 to the mean µ of the third drive data. At step S303, the controller 120 may also generate the second reference information of 'µ + 9*σ' by adding the value obtained by multiplying the standard deviation σ by 9 to the mean µ of the third drive data.

At step S303, the controller 120 may generate a count value based on whether the third drive data exceeds the reference information. At step S303, in detail, the controller 120 may determine whether the count value, which is generated based on whether the third drive data exceeds the reference information, is greater than a threshold count value to determine whether the motor is malfunctioning.

At step S303, the controller 120 may determine that the motor is malfunctioning, when the generated count value is greater than the threshold count value and may generate an abnormal signal for the motor.

At step S303, when the count value is equal to or less than the threshold count value, the controller 120 may determine that the motor is functioning normally.

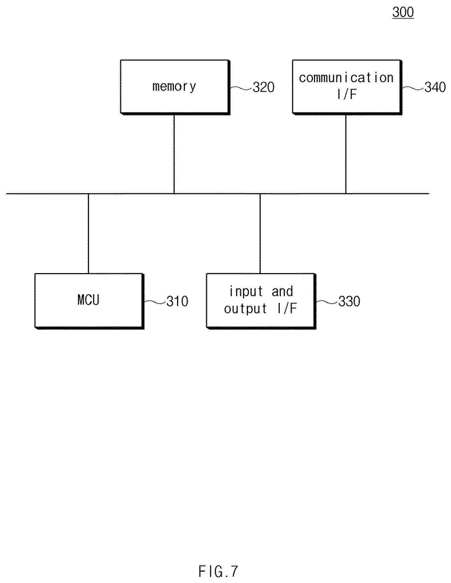

FIG. 7 is a diagram illustrating a hardware configuration of a computing system implementing a monitoring system according to an embodiment disclosed in this document.

With reference to FIG. 7, the computing system 300 according to an embodiment disclosed in this document may include an MCU 310, a memory 320, an input and output I/F 330, and a communication I/F 340.

The MCU 310 may be a processor that executes various programs (e.g., a program for diagnosing malfunctioning of at least one motor) stored in the memory 320, processes various data using these programs, and performs the functions of the monitoring system 100 shown in FIG. 1.

The memory 320 may store various programs related to the operation of the monitoring system 100. In addition, the memory 320 may store operational data of the monitoring system 100.

The memory 320 may be provided in plurality, as necessary. The memory 320 may be a volatile memory or a non-volatile memory. The memory 320 as a volatile memory may be RAM, DRAM, SRAM, or the like. The memory 320 as a non-volatile memory may be ROM, PROM, EAROM, EPROM, EEPROM, flash memory, or the like. The memory 320 is not limited to listed examples and are not limited to these examples.

The input and output I/F 330 is an interface that connects an input device (not shown) such as a keyboard, mouse, or touch panel, an output device such as a display (not shown), and the MCU 310 to transmit and receive data.

The communication I/F 340 may be a component capable of communicating various data with a server, encompassing various devices supporting wired or wireless communication. For example, through the communication I/F 340, it is possible to transmit and receive programs for resistance measurement and anomaly diagnosis, as well as various data, to and from a separately established external server.

In this way, computer programs according to an embodiment disclosed in this document can be recorded in the memory 320 and processed by the MCU 310 to be implemented as modules performing various functions of the monitoring system 100 described, for example, with reference to FIGS. 1 and 2.

## Claims

1. A monitoring system (100) capable of analyzing and controlling the load factor of a servo motor associated with a battery manufacturing device (200, 210, 220, 230) in real-time using a moving average control line, comprising:
a) a data management unit (110) configured to acquire drive data of the servo motor associated with the battery manufacturing device (200, 210, 220, 230) over time and extract a parameter representing a characteristic of the drive data by applying the drive data to an artificial intelligence model; and
b) a controller (120) configured to generate reference information for managing a state of the motor based on the parameter;
**characterized in that**
c) the controller (120) is configured to preprocess the drive data based on the parameter and generate the reference information based on the preprocessed drive data; and
d) the data management unit (110) is configured to extract a first interval to distinguish first drive data obtained during a predetermined period of time before a reference point to be used for generating the reference information and a second interval to distinguish second drive data to be excluded for generating the reference information among the drive data by applying the drive data to an optimizer intelligence model.

2. The monitoring system (100) of claim 1, wherein the controller (120) is configured to generate third drive data by excluding the second drive data obtained during the second interval from the first drive data obtained during the first interval among the drive data.

3. The monitoring system (100) of claim 2, wherein the controller (120) is configured to determine whether the duration corresponding to the third drive data is equal to or longer than a threshold period and generate the reference information based on the third drive data in response to the third drive data being equal to or longer than the threshold period.

4. The monitoring system (100) of claim 3, wherein the controller (120) is configured to calculate a mean and a standard deviation of the third drive data and generate the reference information based on the mean and the standard deviation.

5. The monitoring system (100) of claim 4, wherein the controller (120) is configured to generate a count value based on whether the third drive data exceeds the reference information and determine whether the motor is malfunctioning based on whether the generated count value exceeds a threshold count value.

6. The monitoring system (100) of claim 5, wherein the controller (120) is configured to determine that the motor is malfunctioning based on the count value being greater than the threshold count value and generate an abnormal signal for the motor.

7. The monitoring system (100) of claim 5, wherein the controller (120) is configured to determine that the motor is functioning normally based on the count value being equal to or less than the threshold count value.

8. An operating method of a monitoring system (100) capable of analyzing and controlling the load factor of a servo motor associated with a battery manufacturing device (200, 210, 220, 230) in real-time using a moving average control line, the method comprising:
acquiring drive data of the servo motor associated with a battery manufacturing device (200, 210, 220, 230) over time;
extracting a parameter representing a characteristic of the drive data by applying the drive data to an artificial intelligence model; and
generating reference information for managing a state of the motor based on the parameter;
**characterized in that**
the generating of the reference information for managing the state of the motor based on the parameter comprises preprocessing the drive data based on the parameter and generating the reference information based on the preprocessed drive data; and
the extracting of the parameter representing the characteristic of the drive data by applying the drive data to the artificial intelligence model comprises extracting a first interval to distinguish first drive data obtained during a predetermined period of time before a reference point to be used for generating the reference information and a second interval to distinguish second drive data to be excluded for generating the reference information among the drive data by applying the drive data to an optimizer intelligence model.

9. The method of claim 8, wherein the generating of the reference information for managing the state of the motor based on the parameter comprises generating third drive data by excluding the second drive data obtained during the second interval from the first drive data obtained during the first interval among the drive data.

10. The method of claim 9, wherein the generating of the reference information for managing the state of the motor based on the parameter comprises determining whether a duration corresponding to the third drive data is equal to or longer than a threshold period, and generating the reference information based on the third drive data in response to the third drive data being equal to or longer than the threshold period.

11. The method of claim 10, wherein the generating of the reference information for managing the state of the motor based on the parameter comprises calculating a mean and a standard deviation of the third drive data and generating the reference information based on the mean and the standard deviation.

## Patentansprüche

1. Überwachungssystem (100), das in der Lage ist, den Lastfaktor eines einer Batterieherstellungsvorrichtung (200, 210, 220, 230) zugeordneten Servomotors in Echtzeit unter Verwendung einer Steuerlinie mit gleitendem Durchschnitt zu analysieren und zu steuern, umfassend:
a) eine Datenverwaltungseinheit (110), die dazu eingerichtet ist, Antriebsdaten des der Batterieherstellungsvorrichtung (200, 210, 220, 230) zugeordneten Servomotors über die Zeit zu erfassen und einen Parameter, der eine Eigenschaft der Antriebsdaten repräsentiert, zu extrahieren, indem die Antriebsdaten auf ein Modell künstlicher Intelligenz angewandt werden; und
b) eine Steuerung (120), die dazu eingerichtet ist, auf Grundlage des Parameters Referenzinformation zum Verwalten eines Zustands des Motors zu erzeugen;
**dadurch gekennzeichnet, dass**
c) die Steuerung (120) dazu eingerichtet ist, die Antriebsdaten auf Grundlage des Parameters vorzuverarbeiten und die Referenzinformation auf Grundlage der vorverarbeiteten Antriebsdaten zu erzeugen; und
d) die Datenverwaltungseinheit (110) dazu eingerichtet ist, ein erstes Intervall zur Unterscheidung von ersten Antriebsdaten, die während eines vorbestimmten Zeitraums vor einem Referenzpunkt erhalten wurden, der zur Erzeugung der Referenzinformation verwendet werden soll, und ein zweites Intervall zur Unterscheidung von zweiten Antriebsdaten, die unter den Antriebsdaten für die Erzeugung der Referenzinformation auszuschließen sind, durch Anwenden der Antriebsdaten auf ein KI-Optimierungsmodell zu extrahieren.

2. Überwachungssystem (100) nach Anspruch 1, wobei die Steuerung (120) dazu eingerichtet ist, dritte Antriebsdaten zu erzeugen, indem unter den Antriebsdaten die während des zweiten Intervalls erhaltenen zweiten Antriebsdaten aus den während des ersten Intervalls erhaltenen ersten Antriebsdaten ausgeschlossen werden.

3. Überwachungssystem (100) nach Anspruch 2, wobei die Steuerung (120) dazu eingerichtet ist, zu bestimmen, ob eine den dritten Antriebsdaten entsprechende Dauer gleich einem Schwellenzeitraum oder länger als dieser ist, und als Reaktion darauf, dass die dritten Antriebsdaten gleich dem Schwellenzeitraum oder länger als dieser sind, die Referenzinformation auf Grundlage der dritten Antriebsdaten zu erzeugen.

4. Überwachungssystem (100) nach Anspruch 3, wobei die Steuerung (120) dazu eingerichtet ist, einen Mittelwert und eine Standardabweichung der dritten Antriebsdaten zu berechnen und die Referenzinformation auf Grundlage des Mittelwerts und der Standardabweichung zu erzeugen.

5. Überwachungssystem (100) nach Anspruch 4, wobei die Steuerung (120) dazu eingerichtet ist, einen Zählwert auf Grundlage dessen zu erzeugen, ob die dritten Antriebsdaten die Referenzinformation überschreiten, und auf Grundlage dessen, ob der erzeugte Zählwert einen Schwellenzählwert überschreitet, zu bestimmen, ob der Motor eine Fehlfunktion aufweist.

6. Überwachungssystem (100) nach Anspruch 5, wobei die Steuerung (120) dazu eingerichtet ist, auf Grundlage dessen, dass der Zählwert größer als der Schwellenzählwert ist, zu bestimmen, dass der Motor eine Fehlfunktion aufweist, und ein abnormes Signal für den Motor zu erzeugen.

7. Überwachungssystem (100) nach Anspruch 5, wobei die Steuerung (120) dazu eingerichtet ist, auf Grundlage dessen, dass der Zählwert gleich dem Schwellenzählwert oder kleiner als dieser ist, zu bestimmen, dass der Motor normal funktioniert.

8. Betriebsverfahren eines Überwachungssystems (100), das in der Lage ist, den Lastfaktor eines einer Batterieherstellungsvorrichtung (200, 210, 220, 230) zugeordneten Servomotors in Echtzeit unter Verwendung einer Steuerlinie mit gleitendem Durchschnitt zu analysieren und zu steuern, wobei das Verfahren umfasst:
Erfassen von Antriebsdaten des einer Batterieherstellungsvorrichtung (200, 210, 220, 230) zugeordneten Servomotors über die Zeit;
Extrahieren eines Parameters, der eine Eigenschaft der Antriebsdaten repräsentiert, indem die Antriebsdaten auf ein Modell künstlicher Intelligenz angewandt werden; und
Erzeugen von Referenzinformation zum Verwalten eines Zustands des Motors auf Grundlage des Parameters;
**dadurch gekennzeichnet, dass**
das Erzeugen der Referenzinformation zum Verwalten des Zustands des Motors auf Grundlage des Parameters das Vorverarbeiten der Antriebsdaten auf Grundlage des Parameters und das Erzeugen der Referenzinformation auf Grundlage der vorverarbeiteten Antriebsdaten umfasst; und
das Extrahieren des Parameters, der die Eigenschaft der Antriebsdaten repräsentiert, durch Anwenden der Antriebsdaten auf das Modell künstlicher Intelligenz das Extrahieren eines ersten Intervalls zur Unterscheidung von ersten Antriebsdaten, die während eines vorbestimmten Zeitraums vor einem Referenzpunkt erhalten wurden, der zur Erzeugung der Referenzinformation verwendet werden soll, und eines zweiten Intervalls zur Unterscheidung von zweiten Antriebsdaten, die unter den Antriebsdaten für die Erzeugung der Referenzinformation auszuschließen sind, durch Anwenden der Antriebsdaten auf ein KI-Optimierungsmodell umfasst.

9. Verfahren nach Anspruch 8, wobei das Erzeugen der Referenzinformation zum Verwalten des Zustands des Motors auf Grundlage des Parameters das Erzeugen dritter Antriebsdaten umfasst, indem unter den Antriebsdaten die während des zweiten Intervalls erhaltenen zweiten Antriebsdaten aus den während des ersten Intervalls erhaltenen ersten Antriebsdaten ausgeschlossen werden.

10. Verfahren nach Anspruch 9, wobei das Erzeugen der Referenzinformation zum Verwalten des Zustands des Motors auf Grundlage des Parameters das Bestimmen, ob eine den dritten Antriebsdaten entsprechende Dauer gleich einem Schwellenzeitraum oder länger als dieser ist, und das Erzeugen der Referenzinformation auf Grundlage der dritten Antriebsdaten als Reaktion darauf, dass die dritten Antriebsdaten gleich dem Schwellenzeitraum oder länger als dieser sind, umfasst.

11. Verfahren nach Anspruch 10, wobei das Erzeugen der Referenzinformation zum Verwalten des Zustands des Motors auf Grundlage des Parameters das Berechnen eines Mittelwerts und einer Standardabweichung der dritten Antriebsdaten und das Erzeugen der Referenzinformation auf Grundlage des Mittelwerts und der Standardabweichung umfasst.

## Revendications

1. Système de surveillance (100) apte à analyser et commander le facteur de charge d'un servomoteur associé à un dispositif de fabrication de batterie (200, 210, 220, 230) en temps réel au moyen d'une ligne de commande de moyenne mobile, comprenant :
a) une unité de gestion de données (110) configurée pour acquérir dans le temps des données d'entraînement du servomoteur associé au dispositif de fabrication de batterie (200, 210, 220, 230), et extraire un paramètre représentant une caractéristique des données d'entraînement en appliquant les données d'entraînement à un modèle d'intelligence artificielle ; et
b) un contrôleur (120) configuré pour générer des informations de référence afin de gérer un état du moteur sur la base du paramètre ;
**caractérisé en ce que**
c) le contrôleur (120) est configuré pour prétraiter les données d'entraînement sur la base du paramètre et générer les informations de référence sur la base des données d'entraînement prétraitées ; et
d) l'unité de gestion de données (110) est configurée pour extraire un premier intervalle afin de distinguer des premières données d'entraînement obtenues pendant une période prédéterminée avant un point de référence à utiliser pour générer les informations de référence, et un deuxième intervalle afin de distinguer des deuxièmes données d'entraînement à exclure pour générer les informations de référence parmi les données d'entraînement en appliquant les données d'entraînement à un modèle d'intelligence optimisateur.

2. Système de surveillance (100) selon la revendication 1, où le contrôleur (120) est configuré pour générer des troisièmes données d'entraînement en excluant les deuxièmes données d'entraînement obtenues pendant le deuxième intervalle des premières données d'entraînement obtenues pendant le premier intervalle parmi les données d'entraînement.

3. Système de surveillance (100) selon la revendication 2, où le contrôleur (120) est configuré pour déterminer si la durée correspondant aux troisièmes données d'entraînement est égale ou supérieure à une période seuil, et générer les informations de référence sur la base des troisièmes données d'entraînement en réaction à ce que les troisièmes données d'entraînement sont égales ou supérieures à la période seuil.

4. Système de surveillance (100) selon la revendication 3, où le contrôleur (120) est configuré pour calculer une moyenne et un écart-type des troisièmes données d'entraînement et générer les informations de référence sur la base de la moyenne et de l'écart-type.

5. Système de surveillance (100) selon la revendication 4, où le contrôleur (120) est configuré pour générer une valeur de compteur selon que les troisièmes données d'entraînement excèdent les informations de référence, et déterminer si le moteur présente un dysfonctionnement selon que la valeur de compteur générée est supérieure à une valeur de compteur seuil.

6. Système de surveillance (100) selon la revendication 5, où le contrôleur (120) est configuré pour déterminer que le moteur présente un dysfonctionnement sur la base d'une valeur de compteur supérieure à la valeur de compteur seuil, et pour générer un signal d'anomalie pour le moteur.

7. Système de surveillance (100) selon la revendication 5, où le contrôleur (120) est configuré pour déterminer que le moteur fonctionne normalement sur la base d'une valeur de compteur égale ou inférieure à la valeur de compteur seuil.

8. Procédé de fonctionnement d'un système de surveillance (100) apte à analyser et commander le facteur de charge d'un servomoteur associé à un dispositif de fabrication de batterie (200, 210, 220, 230) en temps réel au moyen d'une ligne de commande de moyenne mobile, ledit procédé comprenant :
l'acquisition dans le temps de données d'entraînement du servomoteur associé à un dispositif de fabrication de batterie (200, 210, 220, 230) ;
l'extraction d'un paramètre représentant une caractéristique des données d'entraînement en appliquant les données d'entraînement à un modèle d'intelligence artificielle ; et
la génération d'informations de référence pour gérer un état du moteur sur la base du paramètre ;
**caractérisé en ce que**
la génération des informations de référence pour gérer l'état du moteur sur la base du paramètre comprend le prétraitement des données d'entraînement sur la base du paramètre et
la génération des informations de référence sur la base des données d'entraînement prétraitées ; et
l'extraction du paramètre représentant la caractéristique des données d'entraînement par application des données d'entraînement au modèle d'intelligence artificielle comprend l'extraction d'un premier intervalle pour distinguer les premières données d'entraînement obtenues pendant une période de temps prédéterminée avant un point de référence à utiliser pour générer les informations de référence, et d'un deuxième intervalle pour distinguer des deuxièmes données d'entraînement à exclure afin de générer les informations de référence parmi les données d'entraînement en appliquant les données d'entraînement à un modèle d'intelligence optimisateur.

9. Procédé selon la revendication 8, où la génération des informations de référence pour gérer l'état du moteur sur la base du paramètre comprend la génération de troisièmes données d'entraînement par exclusion des deuxièmes données d'entraînement obtenues pendant le deuxième intervalle des premières données d'entraînement obtenues pendant le premier intervalle parmi les données d'entraînement.

10. Procédé selon la revendication 9, où la génération des informations de référence pour gérer l'état du moteur sur la base du paramètre comprend la détermination si une durée correspondant aux troisièmes données d'entraînement est égale ou supérieure à une période seuil, et la génération des informations de référence sur la base des troisièmes données d'entraînement en réaction à ce que les troisièmes données d'entraînement sont égales ou supérieures à la période seuil.

11. Procédé selon la revendication 10, où la génération des informations de référence pour gérer l'état du moteur sur la base du paramètre comprend le calcul d'une moyenne et d'un écart-type des troisièmes données d'entraînement, et la génération des informations de référence sur la base de la moyenne et de l'écart-type.
